# EUROPÄISCHE PATENTSCHRIFT

(11) **EP 1 412 991 B1**
(45) Veröffentlichungstag und Bekanntmachung des Hinweises auf die Patenterteilung: **02.04.2008**
(21) Anmeldenummer: 02758356.6
(22) Anmeldetag: 18.07.2002
(51) Int. Cl.: H01L 51/00

(54) **LÖSUNGEN ORGANISCHER HALBLEITER**
SOLUTIONS OF ORGANIC SEMICONDUCTORS
SOLUTIONS DE SEMICONDUCTEURS ORGANIQUES

(30) Priorität: 21.07.2001 DE 10135640
(43) Veröffentlichungstag der Anmeldung: 28.04.2004
(73) Patentinhaber: Merck Patent GmbH, 64293 Darmstadt (DE)
(72) Erfinder: SPREITZER, Hubert, 68519 Viernheim (DE); HEUN, Susanne, 65812 Bad Soden (DE); TREACHER, Kevin, Northwich, Cheshire CW8 4TG (GB); TALLANT, Neil, Whitefield, Manchester M45 6TE (GB); YEATES, Stephen, Macclefield, Cheshire SK10 3PU (GB); BROWN, Beverly, Stockton Hearth, Warrington WA4 2EF (GB)
(86) Internationale Anmeldenummer: PCT/EP2002/007978
(87) Internationale Veröffentlichungsnummer: WO 2003/019693

(56) Entgegenhaltungen:
- EP-A- 1 083 775
- WO-A-02/072714
- WO-A-03/038923
- US-A- 5 681 381
- HEBNER T R ET AL: "INK-JET PRINTING OF DOPED POLYMERS FOR ORGANIC LIGHT EMITTING DEVICES" APPLIED PHYSICS LETTERS, AMERICAN INSTITUTE OF PHYSICS. NEW YORK, US, Bd. 72, Nr. 5, 2. Februar 1998 (1998-02-02), Seiten 519-521, XP000737411 ISSN: 0003-6951

## Beschreibung

Die vorliegende Erfindung betrifft Lösungen organischer Halbleiter sowie deren Verwendung in der Elektronikindustrie.

In einer Reihe von verschiedenartigen Anwendungen, die im weitesten Sinne der Elektronikindustrie zugerechnet werden können, ist der Einsatz organischer Halbleiter als Wirkkomponenten (= Funktionsmaterialien) seit geraumer Zeit Realität bzw. wird in naher Zukunft erwartet.
So finden schon seit etlichen Jahren Ladungstransportmaterialien auf organischer Basis (i. d. R. Lochtransporter auf Triarylaminbasis) Verwendung in Kopiergeräten. Die Verwendung spezieller halbleitender organischer Verbindungen, die zum Teil auch zur Emission von Licht im sichtbaren Spektralbereich befähigt sind, steht gerade am Anfang der Markteinführung, zum Beispiel in Organischen bzw. Polymeren Elektrolumineszenz-Vorrichtungen.
Die Verwendung organischer Ladungstransportschichten in Anwendungen wie Organischen Integrierten Schaltungen (Organischen ICs) und Organischen Solarzellen ist zumindest im Forschungsstadium schon sehr weit gediehen, so daß eine Markteinführung innerhalb der nächsten Jahre erwartet werden kann.
Die Anzahl weiterer Möglichkeiten ist sehr groß, häufig jedoch nur als Abwandlung der oben aufgeführten Prozesse zu sehen, wie die Beispiele Organische Feststofflaserdioden und Organische Photodetektoren belegen.
Bei einigen dieser modernen Anwendungen ist die Entwicklung teilweise bereits sehr weit fortgeschritten, dennoch besteht - je nach Applikation - immer noch ein immenser Bedarf an technischen Verbesserungen.

Bei den Organischen-Elektrolumineszenz-Vorrichtungen bzw. deren Einzelbauteilen, den Organischen-Lichtemittierenden-Dioden (OLEDs), ist die Markteinführung bereits erfolgt, wie die im Markt erhältlichen Autoradios mit "Organischem Display" der Firma Pioneer belegen. Auch bei der hochmolekularen Variante (den Polymeren Lichtemittierenden Dioden, PLED) ist eine Markteinführung in nächster Zeit zu erwarten. Trotz allem sind hier noch deutliche Verbesserungen nötig, um diese Displays zu einer echten Konkurrenz zu den derzeit marktbeherrschenden Flüssigkristallanzeigen (LCD) zu machen bzw. diese zu überflügeln.
Der allgemeine Aufbau solcher PLEDs ist in WO 90/13148 wiedergegeben. Weitere Ausgestaltungsformen solcher PLEDs wie Passiv-Matrix-Adressierung und Aktiv-Matrix-Adressierung sind in den weiter unten genannten Literaturstellen erläutert.

Für die PLEDs zeichnet sich die Entwicklung hin zu vollfarbigen Anzeigevorrichtungen ab. Um zu einer solchen vollfarbigen Anzeigevorrichtung zu kommen, ist es nötig, Beschichtungsverfahren zu entwickeln, die es erlauben, die drei Grundfarben (rot, grün, blau, RGB) räumlich getrennt aufzubringen. Da die Polymere aus Lösung aufgebracht werden, sind hierbei Druckverfahren die Möglichkeit der Wahl.
Derzeit wird wegen der guten Steuerbarkeit, der erreichbaren Auflösung und der großen Variabilität, hauptsächlich an Tintenstrahldruck-Verfahren (ink-jet printing, IJP) gearbeitet. Grundsätzlich eignen sich aber auch andere Druckverfahren, wie z.B. Offsetdruck, Transferdruck, oder Tiefdruckverfahren.

Das Tintenstrahldruck-Verfahren zur Herstellung von PLEDs und entsprechenden Displays ist bereits mehrfach im Stand der Technik beschrieben.

Dieser nächstliegende Stand der Technik wird im folgenden beschrieben:
In EP-A-0880303 ist das Prinzip und die Verwendung von IJP zur Herstellung von PLEDs erstmals beschrieben. Gemäß EP-A-0880303 wird eine Lösung eines "organischen Lumineszenzmaterials" bzw. eine Lösung eines entsprechenden Precursors durch IJP auf ein photolithographisch vorbereitetes Substrat, welches Partitionierungen und Anode enthält, aufgebracht.
Durch die Verwendung verschiedenartiger Lösungen können so verschiedenfarbige Pixel erzeugt werden. In dieser Anmeldung wird mehr das Prinzip, weniger aber die technische Lehre, welche die praktische Durchführung und die dabei zu lösenden Probleme aufzeigt, gelehrt.

In EP-A-1083775 (= WO 00/59267) werden erstmalig verschiedene Probleme von Lösungen für die Herstellung organischer Filme durch IJP aufgezeigt. Darüber hinausgehende Probleme und die möglichen Lösungsansätze für diese Aufgaben sind in der nicht-offengelegten Anmeldeschrift DE 10111633.0 beschrieben. Diese beiden Anmeldungen werden via Zitat als Bestandteil dieser vorliegenden Anmeldeschrift betrachtet.

In EP-A-1083775 wird in den Figuren 1 und 2 ein Detail bei der Herstellung von Aktiv-Matrix-Polymer LEDs (AM-PLEDs) beschrieben, das in der praktischen Durchführung zu Problemen führen kann. Dieses hier erwähnte Detail wird in EP-A-989778 noch genauer erläutert.
Die unterschiedlichen Pixel (Bildpunkte) werden durch Dämme (Separatoren) voneinander abgetrennt. Diese Separatoren bestehen - dies ist Standard bei der Herstellung von AM-LCD Displays - z. B. aus Polyimid. Es können hier natürlich auch andere Polymere verwendet werden, wie z. B. Polyacrylate und Polymethacrylate. Gemeinsam ist diesen Materialien, daß sie durch einen Lösungsprozeß aufgebracht und anschließend photostrukturiert werden.
In aller Regel sind diese Bankmaterialien relativ polar, d. h. es ist relativ schwierig beispielsweise Dispersionen oder Lösungen leitfähiger Polymere (z. B. Polythiophenderivate, wie PEDOT, oder Polyanilinderivate, wie PANI) von diesen Bänken in die eigentlich vorgesehen Pixel zu befördern. Dies gilt sowohl, wenn eine Vollflächenbeschichtung (z. B. via Spin-Coating) durchgeführt wird, als auch bei Verwendung eines ortsauflösenden Druckverfahrens, z. B. Ink-Jet-Printing, wenn die Tropfen nicht exakt in die Pixel treffen. Durch die stark polare Oberfläche werden dann entweder ausschließlich oder zumindest zum Teil die Dämme benetzt, so daß das aktive Material auf diesen Separatoren eintrocknet und so seine eigentliche Funktion nicht bzw. höchstens zum Teil erfüllen kann.
Analoges gilt auch für weniger polare Lösungen organischer Halbleiter, wie z. B. Lösungen lichtemittierender Polymere. Hier kommt es dann zusätzlich - bei nicht vollständiger Bedeckung der Pixel - zu dem Problem, daß es beim späteren Bedampfen mit Kathodenmaterial zum Kontakt zwischen Kathode und Anode bzw. leitfähigen Polymer kommt, was zum Kurzschluß führt.

Um dieses Problem zu umgehen, versucht man, die Oberflächenenergie der Bank herabzusetzen. Dies wird standardmäßig durch das Behandeln mit einem CF₄-Plasma erreicht (vgl. z. B. EP-A-1 083775), was zu einer stabilen, nicht genau definierten Oberfläche führt, die sehr viele CF₃-, CF₂- und CF-Gruppen aufweist. Durch Dauer und Intensität der Behandlung kann man so die Oberflächenenergie einstellen (vgl. auch die Angaben in EP-A-989778).

Es hat sich nun gezeigt, daß diese Behandlung hilft, die sehr polaren Lösungen bzw. Dispersionen organischer Leiter (s. o.) vollständig in die vorgesehenen Pixel zu bringen.
Die weniger polaren Lösungen organischer Halbleiter werden durch diese Oberflächenbehandlung - entgegen den Angaben in EP-A-989778 - allerdings nur zum Teil unterstützt, d. h. es kann weiterhin zu dem Problem kommen, daß Teile der Lösung, die bei der Beschichtung auf das Bankmaterial gelangen, auch dort eintrocknen und somit nicht für die eigentliche Verwendung zur Verfügung stehen. Dies bringt nun mehrere deutliche Nachteile:
1. Das Beschichtungsverfahren ist unzuverlässig. Es kann Pixel geben, die kein oder zu wenig aktives Material enthalten. Dies führt zum Ausfall dieser Pixel. Problematisch ist hierbei, daß selbst bei großen Bildschirmen mit vielen 100000 Bildpunkten der Ausfall von nur einzelnen Pixeln bereits störend wirkt und somit zu einem Produkt führt, das die Spezifikationen nicht erfüllt.
2. Will man Problem 1 umgehen, kann dies zu deutlich erhöhtem Kontrollaufwand bzw. deutlich erhöhtem Verbrauch an aktivem Material führen, um sicher zu gehen, daß in jedem Pixel genügend aktives Material enthalten ist.

Es ist daher von starkem Interesse, für den zuletzt geschilderten Problemkreis technische Lösungen anzubieten. Dies ist Aufgabe der vorliegenden Erfindung.

Aufgabe der Erfindung ist es somit Lösungen organischer Halbleiter bereit zu stellen, die bei der Beschichtung auf Substrate, welche behandelte Separatoren enthalten, diese nicht oder kaum benetzen und möglichst vollständig in die Zwischenräume (z. B. Pixel) fließen.

Dabei gilt als Randbedingung, daß sich die Anwendungseigenschaften, der aus diesen Lösungen hergestellten Schichten gegenüber konventionellen Lösungen nicht verschlechtern.

Lösungen organischer Halbleiter, vor allem für die Verwendung zur Herstellung von PLED-Displays, sind in den bereits oben genannten Anmeldeschriften EP-A-1083775 und DE 10111633.0 und der weiteren Anmeldeschrift EP-A-1103590 beschrieben.

Diese bestehen im allgemeinen aus einem oder mehreren organischen Lösemitteln und aus einem oder mehreren organischen Halbleitern.

Als organische Lösemittel werden in EP-A-1083775 vor allem hochsiedende aromatische Lösemittel mit einem bevorzugten Siedepunkt über 200°C vorgeschlagen, die folgendes Kennzeichen aufweisen: es handelt sich um Benzolderivate, die mindestens drei C-Atome in der oder den Seitenketten besitzen. Bevorzugt werden in der genannten Anmeldung Lösemittel wie Tetralin, Cyclohexylbenzol, Dodecylbenzol und ähnliche genannt. EP-A-1103590 berichtet in Analogie dazu allgemein von Lösemitteln mit einem Dampfdruck (bei der Temperatur des Beschichtungsprozesses) von weniger als 500 Pa (5 mbar), bevorzugt von weniger als 250 Pa (2.5 mbar) und beschreibt hierzu erneut Lösemittel oder Lösemittelgemische von hauptsächlich (hoch)substituierten Aromaten.
In DE 10111633.0 werden hingegen Lösemittelgemische, bestehend aus mindestens zwei verschiedenen Lösemitteln, von denen eines im Bereich von 140 bis 200°C siedet, genannt. Im allgemeinen werden hier ebenfalls Lösemittelgemische, die hauptsächlich organische Lösemittel, wie Xylole, substituierte Xylole, Anisol, substituierte Anisole, Benzonitril, substituierte Benzonitrile, oder auch Hetrocyclen, wie Lutidin, enthalten, beschrieben.

Die organischen Halbleiter unterliegen prinzipiell keiner Einschränkung. Allerdings sind auch diese - wie beispielsweise in DE 10111633.0 - näher zu beschreiben: Erfindungsgemäß können sowohl niedermolekulare organische Halbleiter als auch polymere organische Halbleiter eingesetzt werden.

Organische Halbleiter im Sinne dieses Textes sind organische oder auch metallorganische Verbindungen, die - als Feststoff bzw. als konkrete Schichthalbleitende Eigenschaften aufweisen, d. h. bei denen die Energielücke zwischen Leitungs- und Valenzband zwischen 0.1 und 4 eV liegt.

Beispiele für die in den erfindungsgemäßen Lösungen eingesetzten organischen Halbleiter sind niedermolekulare organische Halbleiter auf Basis von Triarylaminen (Proc. SPIE-Int. Soc. Opt Eng. 1997, 3148, 306-312), Aluminium-tris-(8-hydroxychinolin) (Appl. Phys. Lett. 2000, 76(1), 115-117), Pentacene (Science 2000, 287(5455), 1022-9023), Oligomere (Opt Mater. 1999, 12(2/3), 301-305), weitere kondensierte aromatische Systeme (Mater. Res. Soc. Symp. Proc. 2000, 598, BB9.5/1-BB9.5/6) und weitere Verbindungen, wie sie beispielsweise in J. Mater. Chem, 2000, 10(7), 1471-1507 und Handb. Adv. Electron. Photonic Mater, Devices 2001, 10, 1-51 beschrieben sind. Die in den vorstehend genannten Stellen offenbarten niedermolekularen Halbleiter sind durch Zitat Bestandteil der vorliegenden Beschreibung und deren Erfindung.

Bevorzugt werden in den erfindungsgemäßen Lösungen jedoch polymere organische oder metallorganische Halbleiter verwendet.

Als polymere organische Halbleiter im Sinne der vorliegenden Beschreibung werden insbesondere
(i) die in EP-A-0443861, WO 94/20589, WO 98/27136, EP-A-1025183, WO 99/24526, DE-A-19953806 und EP-A-0964045 offenbarten, in organischen Lösemitteln löslichen, substituierten Poly-p-Arylen-Vinylene (PAVs),
(ii) die in EP-A-0842208, WO 00/22027, WO 00/22026, DE-A-19981010, WO 00/46321, WO 99/54385, WO 00/55927 offenbarten, in organischen Lösemitteln löslichen, substituierten Poly-Fluorene (PFs),
(iii) die in EP-A-0707020, WO 96/17036, WO 97/20877, WO 97/31048, WO 97/39045 offenbarten, in organischen Lösemitteln löslichen, substituierten Poly-Spirobifiluorene (PSFs),
(iv) die in WO 92/18552, WO 95/97955, EP-A-0690086, EP-A-0699699 offenbarten, in organischen Lösemittel löslichen, substituierten Poly-Paraphanylene (PPPs),
(v) die in EP-A-1028136, WO 95/05937 offenbarten, in organischen Lösemitteln löslichen, substituierten Polythiophene (PTs),
(vi) die in T. Yamamoto et al., J. Am. Chem. Soc. 1994, 116, 4832 offenbarten, in organischen Lösemitteln löslichen Polypyridine (PPys),
(vii) die in V. Gelling et al., Polym. Prepr. 2000, 41, 1770 offenbarten in organischen Lösemitteln löslichen Polypyrrole,
(viii) substituierte, lösliche Copolymere, die Struktureinheiten von zwei oder mehr der Klassen (i) bis (vii) aufweisen,
(ix) die in Proc. of ICSM '98, Part I & II (in: Synth. Met 1999, 101 + 102*)* offenbarten, in organischen Lösemitteln löslichen konjugierten Polymere,
(x) substituierte und unsubstituierte Poly-vinyl-carbazole (PVKs), wie beispielsweise in R. C. Penwell et al., J. Polym. Sci., Macromol. Rev. 1978, 13, 63-160 offenbart und
(xi) substituierte und unsubstuierte Triarylaminpolymere, wie vorzugsweise die in JP 2000-072722 offenbarten, verstanden.
Diese polymeren organischen Halbleiter sind durch Zitat Bestandteil der vorliegenden Erfindung.

Als metallorganische Halbleiter eignen sich sowohl definierte metallorganische Komplexe, wie diese beispielsweise in US-A-6048630 und WO-01/08230 beschrieben sind, aber auch metallorganische Komplexe, die in Polymere einpolymerisiert sind, wie diese beispielsweise in der nicht-offengelegten Anmeldeschrift DE 10114477.6 beschrieben sind.

Die erfindungsgemäß eingesetzten polymeren organischen Halbleiter können auch gedoped und/oder als Blend untereinander eingesetzt werden.
Gedoped soll hier bedeuten, daß ein oder mehrere niedermolekulare Substanzen in das Polymer eingemischt werden; Blend sind Mischungen von mehr als einem Polymer, welche nicht zwangsweise alle elektrooptische Aktivität zeigen müssen.

Die erfindungsgemäßen Lösungen und Dispersionen enthalten zwischen 0.01 und 20 Gew%, bevorzugt zwischen 0.1 und 15 Gew%, besonders bevorzugt zwischen 0.25 und 10 Gew%, ganz besonders bevorzugt zwischen 0.25 und 5 Gew% des organischen Halbleiters. Dabei ist es auch erfindungsgemäß eine Mischung / Blend aus mehr als einem organischen Halbleiter einzusetzen.

Diese in den oben genannten Anmeldungen beschriebenen Lösungen organischer Halbleiter weisen in der Regel das Problem auf, daß sie auch auf den oben beschriebenen behandelten Separatoren haften oder teilweise haften bleiben. Somit weisen sie zumindest zum Teil die oben genannten Probleme auf.

Es wurde nun überraschend gefunden, daß man die Lösungen, wie sie in den genannten Anmeldungen EP- A-1083775, EP- A-1103590 und DE 10111633.0 beschrieben sind, durch Zugabe von Additiven in hervorragender Weise verbessern kann, so daß diese anschließend nicht mehr auf den behandelten Bankmaterialien haften und somit die oben erläuterten Nachteile beheben.
Werden diese Additive in einem technisch sinnvollen Konzentrationsbereich eingesetzt, so bleiben auch die Anwendungseigenschaften der erzeugten Filme unverändert.

Gegenstand der Erfindung sind also Lösungen organischer Halbleiter, die ein oder mehrere Additive enthalten.
Diese Additive sind weder Lösemittel für die organischen Halbleiter, noch organische Halbleiter selbst.

Die erfindungsgemäßen Additive sind organische Siloxan-haltige Verbindungen, vorzugsweise Verbindungen, die ein oder mehrere -O-SiR¹R²- Gruppen enthalten, wobei
- R¹, R²: gleich oder verschieden H, einer linearen, verzweigten oder cyclischen C₁-bis C₁₂-Alkyigruppe, bei der auch ein oder mehrere nicht aufeinanderfolgende C-Atome durch O oder S ersetzt sein können, und auch ein oder mehrere H-Atome durch F substituiert sein können, einem C₂- bis C₁₄-Aromaten oder Heteroaromaten, der gegebenenfalls durch ein oder mehrere Substituenten R³ substituiert sein kann;
- R³: gleich oder verschieden einer linearen, verzweigten oder cyclischen C₁ bis C₁₂-Alkyl- oder Alkoxygruppe, bei der auch ein oder mehrere nicht aufeinanderfolgende C-Atome durch O oder S ersetzt sein können, und auch ein oder mehrere H-Atome durch F substituiert sein können, F oder Cl;
gilt.

Die erfindungsgemäßen Siloxan-haltigen Verbindungen enthalten dabei bevorzugt mehr als 50%, besonders bevorzugt mehr als 75% Siloxaneinheiten, bezogen auf die gesamte Zahl von Wiederholeinheiten im Molekül.

Erfindungsgemäße Lösungen sind nun Lösungen gemäß den genannten Anmeldungen EP-A-1083775, EP-A-1103590 und DE 10111633.0, welche neben den Lösemitteln und den organischen Halbleitern noch ein oder mehrere erfindungsgemäße Additive in einer technisch sinnvollen Konzentration enthalten.

Eine technisch sinnvolle Konzentration des Additives bewegt sich je nach Anwendung im Bereich von 0.01% bis zu 50% (Massen-Anteile) bezogen auf den Anteil des/der organischen Halbleiter in der Lösung. Bevorzugt ist dabei der Bereich von 0.01 % bis 10%, besonders bevorzugt der Bereich von 0.01% bis 2%. Dies bedeutet, daß sich - bei einer beispielsweisen Verwendung einer 1 %igen Halbleiterlösung (m/v; Masse/Volumen) - dieses Intervall im Bereich von 0.0001 bis 0.5% (m/v) Additiv zu Lösemittel bewegt.

Die erfindungsgemäßen Additive sind, wie oben beschrieben, Siloxane oder siloxanhaltige Verbindungen, entweder als reine Stoffe oder als Mischung mindestens zweier Stoffe zugesetzt.

Diese können nun niedermolekularer Natur sein (d. h. mit einem Molekulargewicht von weniger als 1000 g/mol) oder auch polymerer Natur sein (d. h. mit einem Molekulargewicht von mindestens 1000 g/mol).

Niedermolekulare Siloxane bzw. siloxanhaltige Verbindungen können lineare Verbindungen mit ca. 1 bis 10 Siloxaneinheiten sein, wie beispielsweise Tetraalkylsiloxane, Hexaalkyldisiloxane, Oktaalkyltrisiloxane, Decaalkyltetrasiloxane, Dodecaalkylpentasiloxane, Tetraarylsiloxane, Hexaaryldisiloxane, Oktaaryltrisiloxane, Decaaryltetrasiloxane, Dodecaarylpentasiloxane, aber auch gemischte Alkyl-Aryl-oligosiloxane; diese mono- oder oligosiloxanhaltigen Gruppen können beispielsweise auch nicht-siloxanartige Gruppen oder Endgruppen aufweisen, wie Wasserstoff, Chlor, Fluor, Amino-, Dialkylamino-, Carbonyloxy-, Carbonsäure-, Alkin-, Alken-, Mercapto-, Alkyloxy- oder Aryloxygruppen und weitere.

Des weiteren können die niedermolekularen Siloxane bzw. siloxanhaltigen Verbindungen auch cyclische Verbindungen sein, wie beispielsweise Hexaalkylcyclotrisiloxan, Oktaalkylcyclotetrasiloxan, Decaalkylcyclopentasiloxan, Hexaarylcyclotrisiloxan, Oktaarylcyclotetrasiloxan, Decaarylcyclopentasiloxan, aber auch gemischte Alkyl-Aryl-cyclo-oligosiloxane; auch hier können einige der Alkyl- oder Arylgruppen durch andere Substituenten, wie Wasserstoff, Chlor, Fluor, Amino-, Dialkylamino-, Carbonyloxy-, Carbonsäure-, Alkin-, Alken-, Mercapto-, Alkyloxy- oder Aryloxygruppen und weitere, ausgetauscht sein.

Polymere Siloxane oder siloxanhaltige Verbindungen können lineare, verzweigte oder auch Makrocyclen enthaltende Struktureinheiten enthalten. Die Polymere können dabei sowohl Homo- als auch Copolymere sein. Copolymere können dabei statistische, alternierende, oder auch Block-Copolymere darstellen.

Erfindungsgemäße polymere Siloxane oder Siloxan-haltige Verbindungen haben ein Molekulargewicht von mindestens 1000 g/mol. Bevorzugt haben sie ein maximales Molekulargewicht von weniger als 100000 g/mol, besonders bevorzugt von weniger als 50000 g/mol, ganz besonders bevorzugt von weniger als 20000 g/mol.

Erfindungsgemäße polymere Siloxane und Siloxan-haltige Verbindungen können beispielsweise Poly-dialkylsiloxane, Poly-diarylsiloxane, Poly-alkyl-aryl-siloxane, Poiy-dialkyl-co-diarylsiloxane, aber auch weitere Copolymere bzw. Polymere, die zusätzlich NICHT-SILOXAN-Gruppen enthalten, bedeuten. Dies sind beispielsweise Siloxan-haltige Copolymere, die neben den Siloxangruppen noch Polyether-, Polyester-, Polyacrylat- oder Polymethacrylatstrukturelemente als Nicht-Siloxan-Gruppen enthalten. Dabei kann es sich um statistische, alternierende, oder auch Block-Copolymere, aber auch "grafted" Copolymere handeln.

Viele der oben beschriebenen Siloxane, cyclischen Siloxane und Poly-siloxane sind kommerziell erhältlich, oder aus kommerziellen Vorstufen leicht zugänglich.

So sind beispielsweise Dodecamethylpentasiloxan (Aldrich), Hexamethylcyclotrisiloxan SIH6105.0 (Gelest/ABCR), Octamethylcyclotetrasiloxan SIO6700.0 (Gelest/ABCR), Triphenyltrimethylcyclotrisiloxan SIT8705.0 (Gelest/ABCR), 1,3,5-Trimethyl-1,3,5-tris(3,3,3-trifluorpropyl)cyclotrisiloxan (Lancaster), 3-Glycidoxypropyl trimethoxysilan (Aldrich), 3-Aminopropyltris(trimethylsiloxy)silan (Fluka), Coatosil 1770 = (Epoxycyclohexyl)ethyltriethoxysilan (Witco) und Dynasilan F8261 =Tridecafluor-1,1,2,2-tetrahydrooctyl-1-triethoxysilan (ABCR) kommerziell erhältlich. Die Bezugsquellen sind jeweils in den Klammern angegeben.

Des weiteren sind beispielsweise auch folgende Polymere kommerziell verfügbar: Poly(dimethylsiloxan) [ = PDMS] [50 cSt DMS-T15] (Gelest/ABCR) Poly(dimethylsiloxan), [100 cSt DMS-T21] (Gelest/ABCR), Poly(dimethylsiloxan) [200 cSt DMS-T22] (Gelest/ABCR), Wacker Silicone fluid AK350 = PDMS [350 cSt] (Wacker/Interorgana), Poly(dimethylsiloxan) [500 cSt DMS-T25] (Gelest/ABCR), Poly(dimethylsiloxan) [200 fluid, 1000 cSt] (Aldrich), Poly(dimethylsiloxan) [200 fluid, 30000 cSt] (Aldrich), Poly(dimethylsiloxan) [30000 cSt DMS-T43] (Gelest/ABCR), Addid 166 = Polydimethylsiloxan [350 cps] (Wacker/NRC), Wacker Silicone Fluid M641 = Mercapto-funktionalisiertes PDMS [200 cPs] (Wacker/Interorgana), Wacker Silicone Fluid IM47 = α,ω-Amino-funktionalisiertes PDMS [130 cPs] (Wacker/Interorgana), Poly-[dimethylsiloxan-co-methylphenylsiloxan] [510 fluid, 50 cSt, 3200 Mₙ, 4900 M_{w}] (Aldrich), Poly-[dimethylsiloxan-*co*-methylphenylsiloxan], [510 fluid, 100 cSt] (Aldrich), Poly-[dimethylsiloxan-*co*-methylphenylsiloxan] [510 fluid, 500 cSt, 8400 Mₙ, 25000 M_{w}] (Aldrich), Poly(methylphenylsiloxan) [500 cSt PMM-0025] (Gelest/ABCR), Phenylmethyl-Dimethylsiloxan Copolymer [30000 cSt PMM-1043, 63000 Mₙ, 120000 M_{w}] (Gelest/ABCR), Poly-[dimethylsiloxan-*co-*methylphenylsiloxan] [710 fluid, 500 cSt] (Aldrich), Poly(dimethylsiloxan-*co-*methylphenylsiloxan, 1:1) [125 cSt PMM-5021] (Gelest/ABCR), Addid 170 = Polymethylphenylsiloxan [200 cSt] (Wacker/NRC), Poly(dimethylsiloxan-*co-*diphenylsiloxan, 19:1) [100 cSt, PDM-0421] (Gelest/ABCR), Poly(dimethylsiloxan-*co-*diphenylsiloxan, 9:1) [100 cSt, PDM-0821] (Gelest/ABCR), Poly(dimethylsiloxan-*co-*diphenylsiloxan, 4:1), [180-230 cSt, PDM-1922] (Gelest/ABCR), Poly-(dimethylsiloxan-*co*-diphenylsiloxan) mit Trimethylsilyl-Endgruppen (Aldrich), Ethylmethyl-Phenylpropylmethylsiloxan Copolymer [ALT-213] (Gelest/ABCR) Byk 323 = Arylalkyl-modifiziertes Pnlymethylalkylsiloxan (Byk), Octadecylmethylsiloxan-dimethylsiloxan Copolymer [ALT-292] (Gelest/ABCR), Poly-(dimethylsiloxan-*co*-alkylsiloxan) (Aldrich), Poly-[dimethylsiloxan-*co*-methyl-(stearoyloxy-alkyl)-siloxan] (Aldrich), Poly-[dimethylsiloxan-*co*-methyl-(3-hydroxypropyl)-siloxan]-*graft*-poly-(ethylenglykol)-methylether (Aldrich), Addid 130 = PDMS-Polyether modifiziert [900 cSt] (Wacker/NRC), Addid 100 = PDMS-Polyether modifiziert [140 cSt] (Wacker/NRC), Addid 210 = PDMS-Polyether modifiziert (Wacker/NRC), Byk UV3510 = Polyether-modifiziertes Polydimethylsiloxan (Byk), Byk 308 = Polyether-modifiziertes Hydroxy-funktionalisiertes Polydimethylsiloxan (Byk), Byk 333 = Polyether-modifiziertes PDMS (Byk), Byk 344 = Polyether-modifiziertes Dimethylpolysiloxan-Copolymer [52% in Xylol/Isobutanol 4/1] (Byk), Baysilone® Paint Additive VP 3739 = Polyether-modifiziertes Methylpolysiloxan [75% aktive Verbindung in Dowanol® DPnB] (Borchers), Dow Coming 54 = Siliconglycol Surfactant (Dow Corning), Dow Coming 56 = Alkylmethyl-Siloxan Additiv (Dow Corning), Byk 310 = 25%ige Lösung Polyester-modifiziertes PDMS (Byk), Poly(3,3,3-trifluoropropylmethylsiloxan) (Gelest/ABCR), Poly[trifluoropropyl(methyl)siloxan] mit TMS-Endgruppen [350cst] (Apollo Scientific), Poly-[dimethylsiloxan-*co*-methyl-(3,3,3-trifluoropropyl)-siloxan] (Aldrich) und Poly-[dimethylsiloxan-*co*-methylsiloxan] (Wacker).

Die hier aufgeführten Siloxane bzw. siloxan-haltigen Verbindungen stellen natürlich nur eine Auswahl der verfügbaren bzw. herstellbaren erfindungsgemäßen Substanzen dar und sollen den Erfindungsgegenstand nicht einschränken.

Wie oben beschrieben ist Erfindungsgegenstand Lösungen organischer Halbleiter dadurch gekennzeichnet, daß sie mindestens ein Siloxan bzw. eine siloxanhaltige Verbindung als Additiv enthalten.

Ein weiterer Erfindungsgegenstand ist die Verwendung der erfindungsgemäßen Lösungen, um Schichten der organischen Halbleiter, insbesondere polymere organische Halbleiter, auf einem Substrat zu erzeugen.

Eine bevorzugte Ausführungsform ist dabei die Verwendung von Druckverfahren zur Herstellung der organischen Halbleiterschichten. Besonders bevorzugt ist dabei die Verwendung von Tintenstrahl-Druckverfahren (IJP).

Noch ein weiterer Erfindungsgegenstand sind die Beschichtungen der organischen Halbleiter, hergestellt unter Verwendung der erfindungsgemäßen Lösungen. Besonders bevorzugt sind dabei die Beschichtungen, die durch die oben beschriebenen Druckverfahren hergestellt werden.

Lösungen im Sinne der vorliegenden Erfindung sind Mischungen von Festsubstanzen in Lösemitteln, welche flüssig sind und in denen die Feststoffe molekular gelöst vorliegen, d. h. die große Mehrzahl der Fesistoffmoleküle liegt tatsächlich gelöst und nicht in Form von Aggregaten bzw. Nano- oder Mikropartikeln vor.

Die Viskosität der erfindungsgemäßen Lösungen ist variabel. Allerdings verlangen gewisse Beschichtungstechniken eine Verwendung gewisser Viskositätsbereiche. So ist für die Beschichtung via IJP ein Bereich von ca. 4 bis 25 mPa*s als sinnvoll anzugeben. Für andere Druckverfahren, z. B. Tiefdruckverfahren, kann aber auch eine deutlich höhere Viskosität, beispielsweise im Bereich von 20 bis 500 mPa*s, durchaus Vorteile ergeben.

Im vorliegenden Anmeldetext und auch in den im weiteren folgenden Beispielen wird meist auf die Zusammensetzung von bzw. die Verwendung erfindungsgemäßer Lösungen in Bezug auf polymere Leuchtdioden und den entsprechenden Displays abgezielt. Trotz dieser Beschränkung der Beschreibung ist es für den Fachmann ohne weiteres erfinderisches Zutun möglich, entsprechende erfindungsgemäße Lösungen auch für die Verwendung in anderen Devices herzustellen und anzuwenden, z. B. für Organische Integrierte Schaltungen (O-ICs), in Organischen Feld-Effekt-Transistoren (OFETs), in Organischen Dünnfilmtransistoren (OTFTs), für Organische Solarzellen (O-SCs) oder auch Organische Laserdioden (O-Laser), um nur einige Anwendungen zu nennen.

Die vorliegende Erfindung wird durch die folgenden Beispiele näher erläutert, ohne sie darauf einschränken zu wollen. Der Fachmann kann aus der Beschreibung und den aufgeführten Beispielen ohne erfinderisches Zutun weitere erfindungsgemäße Lösungen oder Dispersionen bereiten und diese anwenden, um daraus Schichten zu erzeugen.

### Verwendete Additive:

**Tabelle 1 Verwendete Additive.**

| **#** | **Chemischer Name** | **Viskosität** | **Lieferant** |
|---|---|---|---|
| ADD1 | Poly(dimethylsiloxan(90)-co-methylphenylsiloxan(10)) | 500 mPa*s | ALDRICH |
| ADD2 | Polydimethylsiloxan | 1000 mPa*s | ALDRICH |
| ADD3 | Polydimethylsiloxan | 100 mPa*s | GELEST/ABCR |
| ADD4 | Poly(dimethylsiloxan(95)-co-di-phenylsiloxan(5)) | 100 mPa*s | GELEST/ABCR |
| ADD5 | Poly(dimethylsiloxan) mit Mercapto-Endgruppen | 200 mPa*s | WACKER |

### Verwendete Polymer-Lösungen

**Tabelle 2 Verwendete Lösungen organischer Halbleiter. SY18: gelb emittierendes PPV-Derivat, Struktur analog zu Polymer P6 in EP-A-1029019; HB1341: blau emittierendes Poly-Spiro-Derivat, Struktur analog zu Polymer P12 in DE 10114477.6.**

| **#** | **Polymer** | **Lösemittel** | **Konzentration [g/l]** | **Viskosität [mPa*s]** |
|---|---|---|---|---|
| SOL1 | SY18 | 4-Methylanisol | 7.0 | 10.0 @ 500 s⁻¹ |
| SOL2 | SY18 | Anisollo-Xylol (1:1) | 11.0 | 18.2 @ 500 s⁻¹ |
| SOL3 | HB1341 | Anisol/o-Xylol (1:1) | 12.3 | 9.6 @ 500 s⁻¹ |
| SOL4 | HB1341 | Tetralin | 7.5 | 9.2 @ 500 s⁻¹ |

### Beispiel 1:

### Benetzungs- bzw. Gleiteigenschaften von Lösungen organischer Halbleiter auf CF₄-Plasma-behandeltem Polyimid

Wie oben im Anmeldetext beschrieben, weisen Lösungen organischer Halbleiter häufig das Problem auf, auf behandelte Separatoren zu haften. Im Laufe der Untersuchungen haben wir ein einfaches Modellexperiment gefunden, welches diese Eigenschaft gut simuliert, ohne jeweils aufwendige Druckversuche und anschließende mikroskopische Untersuchen durchführen zu müssen. Es hatte sich nämlich herausgestellt, daß folgendes Experiment eine gut vergleichbare Aussage liefert:
Ein Substrat, dessen Oberfläche ein homogener Film aus dem behandelten Bankmaterial ist, wird in eine Drehvorrichtung eingespannt. Das Substrat wird zunächst waagrecht (0°) gestellt. Dann tropft man kleine Tropfen (ca. 3-5 µl) der zu untersuchenden Lösung auf das Substrat. Anschließend wird das Substrat mechanisch allmählich schräger gestellt und der Winkel gemessen, bei dem die Tropfen zu rutschen beginnen.

Tropfen, die sehr schlecht auf dem Bankmaterial haften, rutschen schon bei relativ niedrigen Winkeln, spätestens bei einer Neigung von ca. 70°. Tropfen, die gut haften, rutschen selbst auf senkrecht gestellten Substraten (90°) nicht. Der gefundene Winkel wird Gleitwinkel genannt. Ist dieser 90° bedeutet das, daß der Tropfen nicht rutscht.

Eine Überprüfung hatte mehrfach gezeigt, daß Lösungen, deren Tropfen im Experiment rutschen, auch beim Druckverfahren vom Bankmaterial in die Pixel gleiten, während Lösungen, deren Tropfen im Test nicht rutschen, auch beim Drucken das Bankmaterial benetzen und nicht in die Pixel gleiten. Dieser Zusammenhang ist nicht vollständig geklärt, da es sich im Modellexperiment um Tropfen handelt, deren Volumen im Vergleich zum Druckverfahren um 5 bis 6 Größenordnungen größer ist (5 bis 120 pl im Vergleich zu 3 bis 5 µl), dennoch wurde in vielen Vergleichsexperimenten eine Übertragbarkeit festgestellt.

Für die im folgenden aufgezeigten Untersuchungen wurde CF₄-Plasma behandeltes Polyimid (unstrukturiert) als Substrat verwendet. Es wurden nun mit den oben genannten Lösungen und Additiven folgende Ergebnisse erhalten:

**Tabelle 3 Vergleich von Gleitwinkeln bei unterschiedlichen Lösungen und Additiv-Beladungen. ¹⁾ Konzentration: m/v (Masse/Volumen bezogen auf Lösemittel.**

| **Lösung** | **Additiv** | **Konz. Additiv¹⁾** | **Gleitwinkel** |
|---|---|---|---|
| **SOL1** | - | - | 90° |
| **SOL1** | ADD1 | 0.001% | 84° |
| **SOL1** | ADD1 | 0.01% | 59° |
| **SOL1** | ADD1 | 0.1% | 38° |
| **SOL1** | ADD2 | 0.01% | 67° |
| **SOL1** | ADD3 | 0.01% | 55° |
| **SOL1** | ADD4 | 0.01% | 62° |
| **SOL1** | ADD5 | 0.01% | 63° |
| **SOL2** | - | - | 90° |
| **SOL2** | ADD1 | 0.001% | 78° |
| **SOL3** | - | - | 90° |
| **SOL3** | ADD1 | 0.001% | 68° |
| **SOL4** | - | - | 90° |
| **SOL4** | ADD1 | 0.001% | 73° |
| **SOL4** | ADD1 | 0.01% | 61° |
| **SOL4** | ADD1 | 0.1% | 40° |
| **SOL4** | ADD4 | 0.001% | 75° |
| **SOL4** | ADD4 | 0.01% | 60° |
| **SOL4** | ADD4 | 0.1% | 37° |

Man kann einfach erkennen, daß die Lösungen, welche ohne Additiv jeweils keine Gleiteigenschaften zeigen, durch Zugabe von wenig Additiv jeweils einen Gleitwinkel kleiner 90° zeigen. Dabei wirkt sich eine steigende Zugabe von Additiv in einer stetigen Verkleinerung des Gleitwinkels aus, wobei technisch relevante Effekte bei den hier untersuchten Lösungen im Bereich von ca. 0.01% Additiv-Beladung zu erkennen waren.

### Beispiel 2: EL-Untersuchungen von Lösungen mit Additiv

Wie in der Beschreibung oben festgestellt, müssen die Lösungen organischer Halbleiter auch nach Zusatz von Additiven in der entsprechenden Anwendung immer noch zu Eigenschaften führen, wie diese ohne Additiv erreicht werden.

Aus diesem Grund wurde die Elektrolumineszenz-Performance (EL) von PLEDs, die aus Lösungen mit erfindungsgemäßen Additiven hergestellt wurden, hinsichtlich der wichtigsten Anwendungseigenschaften (Effizienz, Lebensdauer) untersucht und mit den analogen Eigenschaften von Additiv-freien Lösungen verglichen.

Die Präparation von PLEDs erfolgte analog zu den Angaben in den oben zitierten Patentschriften, die Herstellung ist im folgenden kurz beschrieben. Zur Vereinfachung wurden dabei alle Test-Devices via Spin-Coating (Lackschleudern) und nicht durch aufwendigere Druckverfahren erzeugt. Im einzelnen wurde wie folgt vorgegangen:

Die Substrate (ITO, ca. 150 nm auf Glas) wurden durch Ultrabeschallung in Wasser mit einem Spülmittel gereinigt und anschließend durch Einwirken von UV-Strahlung in einem Ozon-Plasma weiter vorbereitet. Auf die so präparierten Substrate wurde zunächst eine dünne Schicht (ca. 20-30 nm) PEDOT (kommerziell von BAYER erhältlich) aufgesponnen. Anschließend wurden diese Substrate in eine Glove-Box transferiert (Ausschluß von Luft!). Hier wurden dann die Schichten lichtemittierender Polymere aufgeschleudert (Schichtdicke ca. 60-90 nm). Darauf wurde dann die Kathode durch thermische Verdampfung im Hochvakuum (< 10⁻⁶ mbar) aufgebracht. Für die hier beschriebenen Ergebnisse wurde eine Doppelkathode bestehend aus Barium (ca. 9 nm) und Silber (ca. 100 nm) verwendet.
Die so erzeugten Test-Devices wurden standardmäßig kontaktiert und auf ihr EL-Verhalten untersucht; anschließend wurde die EL-Lebensdauer einzelner Leuchtdioden untersucht.

**Tabelle 4 Vergleich von EL-Performance-Daten unterschiedlicher Lösungen und Additiv-Beladungen. ¹) Konzentration: m/v bezogen auf Lösemittel.**

| **Lösung** | **Additiv** | **Konz. Additiv¹⁾** | **max. Eff. [Cd/A]** | **U[V] @ 100Cd/m²** | **t_{1/2} [h] @ 10 mA/cm²** |
|---|---|---|---|---|---|
| **SOL1** | - | - | 8.5 | 3.1 | 980 |
| **SOL1** | ADD1 | 0.001% | 8.5 | 3.0 | 980 |
| **SOL1** | ADD1 | 0.01% | 8.5 | 3.1 | 980 |
| **SOL1** | ADD1 | 0.1% | 8.3 | 3.0 | 250 |
| **SOL4** | - | - | 1.5 | 5.1 | 80 |
| **SOL4** | ADD1 | 0.001% | 1.3 | 4.9 | 100 |
| **SOL4** | ADD1 | 0.01% | 1.7 | 5.7 | 90 |
| **SOL4** | ADD1 | 0.1 % | 1.8 | 4.9 | 30 |
| **SOL3** | - | - | 1.5 | 4.7 | 90 |
| **SOL3** | ADD2 | 0.001% | 1.5 | 4.5 | 90 |
| **SOL3** | ADD2 | 0.01% | 1.6 | 4.6 | 90 |
| **SOL3** | ADD2 | 0.1% | 1.4 | 5.4 | 50 |
| **SOL2** | - | - | 9.1 | 3.1 | >1000 |
| **SOL2** | ADD3 | 0.001% | 9.4 | 3.1 | >1000 |
| **SOL2** | ADD3 | 0.01% | 9.0 | 3.2 | >1000 |
| **SOL2** | ADD3 | 0.1 % | 8.5 | 3.3 | 500 |
| **SOL2** | - | - | 9.1 | 3.1 | >1000 |
| **SOL2** | ADD4 | 0.001% | 9.0 | 3.1 | >1000 |
| **SOL2** | ADD4 | 0.01% | 9.1 | 3.1 | >1000 |
| **SOL2** | ADD4 | 0.1% | 8.4 | 3.7 | 200 |
| **SOL2** | - | - | 9.1 | 3.1 | >1000 |
| **SOL2** | ADD5 | 0.001% | 9.4 | 3.1 | >1000 |
| **SOL2** | ADD5 | 0.01% | 9.6 | 3.1 | >1000 |
| **SOL2** | ADD5 | 0.1% | 8.4 | 3.2 | 700 |

Wie man aus den angegebenen Daten leicht entnehmen kann, ist eine Beladung mit Additiv im Bereich bis zu ca. 0.01% ohne erkennbaren Einfluß auf die Performance. Bei hohen Beladungen ist i. d. R. eine Verkürzung der Device-Lebensdauer zu erkennen:
Durch diese Experimente ist jedoch auch klar, daß technisch verwendbare Additiv-Anteile keine negativen Auswirkung auf die Anwendung zeigen.

### Beispiel 3: Ink-Jet Untersuchungen von Lösungen mit Additiv

Da die erfindungsgemäßen Lösungen vor allem für die Verwendung in Druckverfahren gedacht sind, ist eine Untersuchung der Druckeigenschaften sinnvoll. Deshalb wurden Experimente durchgeführt, wie sich Lösungen mit und ohne Additiv beim Drucken mit einem Tintenstrahldruckkopf (IJ-Printing) verhalten. Die Untersuchungen wurden wie folgt durchgeführt:
Die Lösungen wurden mit einem *Spectra Galaxy 256*/*80* Druckkopf gedruckt. Dabei wurde vor allem das Druckverhalten und wichtige Tropfenparameter bestimmt und diese Resultate mit Lösungen ohne Additiv verglichen.

Die Ergebnisse sind in der folgenden Tabelle zusammengefaßt:

**Tabelle 5 Vergleich der Druck-Eigenschaften unterschiedlicher Lösungen und Additiv-Beladungen.**

| **Lösung** | **Additiv** | **Konz. Additiv** | **Druck Parameter** | **Tropfenform** | **Tropfenmasse** | **Kommentar** |
|---|---|---|---|---|---|---|
| **SOL 1** | - | - | 95 V | kurzer Schwanz, der sofort aufholt. | 51 ng | Gute |
| | | | 6.4 µs | | | Druckbarkeit |
| **SOL 1** | ADD1 | 0.001% | 100 V | kurzer Schwanz, der sofort aufholt. | 54 ng | Gute |
| | | | 5.4 µs | | | Druckbarkeit |
| **SOL 1** | ADD1 | 0.01% | 97 V | kurzer Schwanz, der sofort aufholt. | 52 ng | Gute |
| | | | 5.6 µs | | | Druckbarkeit |
| **SOL 1** | ADD1 | 0.1% | 100 V | kurzer Schwanz, der sofort aufholt. | 59 ng | Gute |
| | | | 6.0 µs | | | Druckbarkeit |

Wie man aus den angegebenen Daten leicht erkennen kann, wurden die Druck-Eigenschaften durch die Additivzugabe nur unwesentlich beeinflußt. Es ist mit und ohne Additiv ein problemloses Drucken mit einem entsprechenden TintenstrahlDruckkopf möglich.

## Patentansprüche

1. Lösung eines organischen Halbleiters **dadurch gekennzeichnet, daß** diese ein oder mehrere Additive enthält, wobei mindestens ein Additiv eine organische Siloxan-haltige Verbindung ist.

2. Lösung gemäß Anspruch 1, wobei das organische Siloxan-haltige Additiv ein oder mehrere -O-SiR¹R²- Gruppen enthält, wobei für
R¹, R² gleich oder verschieden H, einer linearen, verzweigten oder cyclischen C₁ bis C₁₂-Alkylgruppe, bei der auch ein oder mehrere nicht aufeinanderfolgende C-Atome durch O oder S ersetzt sein können, und auch ein oder mehrere H-Atome durch F substituiert sein können, einem C₂ bis C₁₄-Aromaten oder Heteroaromaten, der gegebenenfalls durch ein oder mehrere Substituenten R³ substituiert sein kann;
R³ gleich oder verschieden einer linearen, verzweigten oder cyclischen C₁ bis C₁₂-Alkyl- oder Afkoxygruppe, bei der auch ein oder mehrere nicht aufeinanderfolgende C-Atome durch O oder S ersetzt sein können, und auch ein oder mehrere H-Atome durch F substituiert sein können, F oder Cl;
gilt.

3. Lösung gemäß den Ansprüchen 1 und/oder 2 **dadurch gekennzeichnet, daß** die organische Siloxan-haltige Verbindung eine niedermolekulare Verbindung mit einem Molekulargewicht von weniger als 1000 g/mol ist.

4. Lösung gemäß den Ansprüchen 1 und/oder 2 **dadurch gekennzeichnet, daß** die organische Siloxan-haltige Verbindung ein Polymer mit einem Molekulargewicht von mindestens 1000 g/mol ist.

5. Verwendung der Lösungen gemäß einem oder mehreren der Ansprüche 1 bis 4, um Schichten der organischen Halbleiter auf einem Substrat zu erzeugen.

6. Verfahren gemäß Anspruch 5 **dadurch gekennzeichnet, daß** es sich um ein Druckverfahren zur Herstellung der organischen Halbleiterschichten handelt.

7. Verfahren gemäß Anspruch 6 **dadurch gekennzeichnet, daß** es sich um ein Tintenstrahl-Druckverfahren zur Herstellung der organischen Halbleiterschichten handelt.

8. Beschichtungen mit organischen Halbleitern, hergestellt unter Verwendung von Lösungen gemäß einem oder mehreren der Ansprüche 1 bis 4,

9. Beschichtungen mit organischen Halbleitern, hergestellt durch ein Verfahren gemäß einem oder mehreren der Ansprüche 6 oder 7.

10. Elektronisches Bauteil enthaltend ein Substrat und eine Beschichtung gemäß einem oder mehreren der Ansprüche 8 oder 9.

11. Elektronisches Bauteil gemäß Anspruch 10, **dadurch gekennzeichnet, daß** es sich um eine polymere organische Leuchtdiode, eine organische Integrierte Schaltungen (O-ICs), einen organischen Feld-Effekt-Transistor (OFETs), einen organischen Dünnfilmtransistor (OTFTs), eine organische Solarzellen (O-SCs) oder eine organische Laserdiode (O-Laser) handelt.

## Claims

1. Solution of an organic semiconductor, **characterised in that** it comprises one or more additives, where at least one additive is an organic siloxane-containing compound.

2. Solution according to Claim 1, where the organic siloxane-containing additive contains one or more -O-SiR¹R² groups, where
R¹, R², identically or differently, denote H, a linear, branched or cyclic C₁ to C₁₂-alkyl group, in which, in addition, one or more non-consecutive C atoms may be replaced by O or S, and, in addition, one or more H atoms may be substituted by F, or denote a C₂ to C₁₄-aromatic or heteroaromatic radical, which may optionally be substituted by one or more substituents R³;
R³, identically or differently, denotes a linear, branched or cyclic C₁ to C₁₂-alkyl or -alkoxy group, in which, in addition, one or more non-consecutive C atoms may be replaced by O or S, and, in addition, one or more H atoms may be substituted by F, or denotes F or Cl.

3. Solution according to Claims 1 and/or 2, **characterised in that** the organic siloxane-containing compound is a low-molecular-weight compound having a molecular weight of less than 1000 g/mol.

4. Solution according to Claims 1 and/or 2, **characterised in that** the organic siloxane-containing compound is a polymer having a molecular weight of at least 1000 g/mol.

5. Use of the solutions according to one or more of Claims 1 to 4 for the production of layers of the organic semiconductors on a substrate.

6. Process according to Claim 5, **characterised in that** the organic semiconductor layers are produced by a printing process.

7. Process according to Claim 6, **characterised in that** the organic semiconductor layers are produced by an ink-jet printing process.

8. Coatings comprising organic semiconductors, produced using solutions according to one or more of Claims 1 to 4.

9. Coatings comprising organic semiconductors, produced by a process according to one or more of Claims 6 or 7.

10. Electronic component containing a substrate and a coating according to one or more of Claims 8 or 9.

11. Electronic component according to Claim 10, **characterised in that** it is a polymeric organic light-emitting diode, an organic integrated circuit (O-IC), an organic field-effect transistor (OFET), an organic thin-film transistor (OTFT), an organic solar cell (O-SC) or an organic laser diode (O-laser).

## Revendications

1. Solution d'un semiconducteur organique, **caractérisée en ce qu'**elle comprend un ou plusieurs additifs, où au moins un additif est un composé organique contenant du siloxane.

2. Solution selon la revendication 1, dans laquelle l'additif organique contenant du siloxane contient un ou plusieurs groupe -O-SiR¹R², où
R¹, R² de manière identique ou différente, représentent H, un groupe C₁ à C₁₂-alkyle linéaire, ramifié ou cyclique où, en plus, un ou plusieurs atomes de C non consécutifs peut/peuvent être remplacé(s) par O ou par S et en outre, un ou plusieurs atomes de H peut/peuvent être substitué(s) par F ou représente(nt) un radical C₂ à C₁₄-aromatique ou -hétéroaromatique, lequel peut être en option substitué par un ou plusieurs substituants R³ ;
R³ de manière identique ou différente, représente un groupe C₁ à C₁₂-alkyle ou -alcoxy linéaire, ramifié ou cyclique, dans lequel, en plus, un ou plusieurs atomes de C non consécutifs peut/peuvent être remplacé(s) par O ou par S et en outre, un ou plusieurs atomes de H peut/peuvent être substitué(s) par F ou représente(nt) F ou Cl.

3. Solution selon les revendications 1 et/ou 2, **caractérisée en ce que** le composé organique contenant du siloxane est un composé de poids moléculaire faible présentant un poids moléculaire inférieur à 1000 g/mol.

4. Solution selon les revendications 1 et/ou 2, **caractérisée en ce que** le composé organique contenant du siloxane est un polymère présentant un poids moléculaire d'au moins 1000 g/mol.

5. Utilisation des solutions selon une ou plusieurs des revendications 1 à 4 pour la production de couches des semiconducteurs organiques sur un substrat.

6. Procédé selon la revendication 5, **caractérisé en ce que** les couches de semiconducteurs organiques sont produites au moyen d'un procédé d'impression.

7. Procédé selon la revendication 6 , **caractérisé en ce que** les couches de semiconducteurs organiques sont produites au moyen d'un procédé d'impression par jet d'encre.

8. Revêtements comprenant des semiconducteurs organiques, produits en utilisant des solutions selon une ou plusieurs des revendications 1 à 4.

9. Revêtements comprenant des semiconducteurs organiques, produits au moyen d'un procédé selon une ou plusieurs des revendications 6 ou 7.

10. Composant électronique contenant un substrat et un revêtement selon une ou plusieurs des revendications 8 ou 9.

11. Composant électronique selon la revendication 10, **caractérisé en ce qu'**il s'agit d'une diode émettrice de lumière organique polymérique, d'un circuit intégré organique (O-IC), d'un transistor à effet de champ organique (OFET), d'un transistor à film mince organique (OTFT), d'une cellule solaire organique (O-SC) ou d'une diode laser organique (O-laser).
